# EUROPÄISCHE PATENTSCHRIFT

(11) **EP 3 597 018 B1**
(45) Veröffentlichungstag und Bekanntmachung des Hinweises auf die Patenterteilung: **06.04.2022**
(21) Anmeldenummer: 18701449.3
(22) Anmeldetag: 22.01.2018
(51) Int. Cl.: H05K 5/00, H05K 1/14, B60K 23/00, G01D 11/24, H05K 1/02, H05K 3/46, H05K 1/11, H05K 3/36, H05K 3/28, F16H 57/00

(54) **ELEKTRONISCHES STEUERMODUL UND VERFAHREN ZUM HERSTELLEN EINES ELEKTRONISCHEN STEUERMODULS**
ELECTRONIC CONTROL MODULE AND PROCESS FOR MANUFACTURING AN ELECTRONIC MODULE
MODULE ÉLECTRONIQUE DE CONTRÔLE ET PROCÉDÉ DE FABRICATION D'UN MODULE ÉLECTRONIQUE DE CONTRÔLE

(30) Priorität: 15.03.2017 DE 102017204338
(43) Veröffentlichungstag der Anmeldung: 22.01.2020
(73) Patentinhaber: Robert Bosch GmbH, 70442 Stuttgart (DE)
(72) Erfinder: KRAUS, Matthias, 99867 Gotha ot Uelleben (DE)
(86) Internationale Anmeldenummer: PCT/EP2018/051455
(87) Internationale Veröffentlichungsnummer: WO 2018/166679

(56) Entgegenhaltungen:
- WO-A1-2009/153256
- WO-A2-2014/187834
- DE-A1-102013 212 940
- DE-A1-102014 205 385
- DE-A1-102014 205 386
- US-A1- 2007 131 854
- US-A1- 2012 006 907

## Beschreibung

### Gebiet der Erfindung

Die Erfindung betrifft ein elektronisches Steuermodul und ein Verfahren zum Herstellen eines elektronischen Steuermoduls.

### Stand der Technik

Eine Vielzahl von elektronischen Steuermodulen, insbesondere für ein Getriebe, ist bekannt. Die elektronischen Steuermodule umfassen oftmals einen Sensor bzw. ein Sensorelement, mittels dem Messwerte bzw. Messdaten erfasst werden. Das Sensorelement kann Teil einer Sensoreinheit sein. Der Sensor bzw. die Sensoreinheit muss an vorbestimmten Positionen bzw. Abständen relativ zu dem zu messenden Element bzw. Objekt angeordnet werden. Auch die Position des Steuermoduls bzw. eines ersten Leiterplattenelements des Steuermoduls ist oft vorgegeben. Daher muss der Sensor bzw. die Sensoreinheit in einem vorbestimmten Abstand bzw. in einer vorbestimmten Höhe von dem ersten Leiterplattenelement angeordnet werden. Hierfür wird typischerweise ein Sensoreinheitträger verwendet, der auf dem ersten Leiterplattenelement befestigt wird. Auf einer von dem ersten Leiterplattenelement abgewandten Seite des Sensoreinheitträgers ist bzw. wird die Sensoreinheit an dem Sensoreinheitträger befestigt.

Zur elektrischen Verbindung zwischen dem ersten Leiterplattenelement und dem Sensor bzw. der Sensoreinheit wird in der Regel ein Kabel oder ein Stanzgitter verwendet. Bei Verbindung mit einem Kabel ist die Herstellung sehr aufwändig, u.a. da viele unterschiedliche Kontaktiertechnologien verwendet werden. Bei einem Stanzgitter als elektrisches Verbindungselement zwischen Sensor bzw.

Sensoreinheit und dem ersten Leiterplattenelement werden aufwendige und teure Werkzeuge zur Herstellung benötigt. Zudem sind die Werkzeuge nicht schnell veränderbar, so dass die Position der Sensoreinheit während des Herstellungsprozesses nicht leicht veränderbar ist, u.a. da andere Werkzeuge benötigt werden und der Herstellungsprozess aufwendig umgestellt werden muss.

Zudem ist der Winkel zwischen dem Sensor bzw. der Sensoreinheit und dem Leiterplattenelement im Herstellungsprozess nur sehr aufwendig zu ändern.

Die DE 10 2014 205 386 A1 und die DE 10 2014 205 385 A1 beschreiben jeweils ein Elektronikmodul, insbesondere für ein Getriebesteuergerät, gemäß dem Stand der Technik.

### Offenbarung der Erfindung

### Vorteile der Erfindung

Ausführungsformen der vorliegenden Erfindung können in vorteilhafter Weise ermöglichen, den Abstand des Sensorelements von dem ersten Leiterplattenelement sowie den Winkel des Sensorelements relativ zu dem ersten Leiterplattenelement technisch einfach zu ändern bzw. beim Herstellen anzupassen.

Gemäß einem ersten Aspekt der Erfindung wird eine elektronisches Steuermodul, insbesondere für ein Getriebe, vorgeschlagen, umfassend - ein erstes Leiterplattenelement, - einen auf dem ersten Leiterplattenelement befestigten Sensoreinheitträger mit einer Sensoreinheitaufnahme zum Aufnehmen einer Sensoreinheit, - die Sensoreinheit mit einem auf einem zweiten Leiterplattenelement befestigten und mit dem zweiten Leiterplattenelement elektrisch verbundenen Sensorelement zum Erfassen mindestens einen Messwerts, wobei die Sensoreinheit in der Sensoreinheitaufnahme befestigt ist, wobei das zweite Leiterplattenelement einen flexiblen Bereich aufweist, wobei der flexible Bereich einen ersten Teilbereich des zweiten Leiterplattenelements von einem zweiten Teilbereich des zweiten Leiterplattenelements trennt, wobei der erste Teilbereich einen vorbestimmten Winkel zu dem zweiten Teilbereich aufweist, und das Sensorelement mittels des zweiten Teilbereichs des zweiten Leiterplattenelements mit dem ersten Leiterplattenelement elektrisch verbunden ist, wobei der Sensoreinheitträger einen Hohlraum zum Aufnehmen eines elektrischen Verbindungsbereichs zwischen dem zweiten Teilbereich des zweiten Leiterplattenelements und dem ersten Leiterplattenelement aufweist, dadurch gekennzeichnet, dass der Hohlraum gegenüber der Umgebung durch die Sensoreinheit öldicht abgedichtet ist.

Ein Vorteil hiervon ist, dass typischerweise der Abstand der Sensoreinheit bzw. des Sensorelements von dem ersten Leiterplattenelement technisch einfach während des Herstellungsprozesses angepasst bzw. geändert werden kann. Darüber hinaus ist der Winkel bzw. die Ausrichtung zwischen der Sensoreinheit bzw. dem Sensorelement und dem ersten Leiterplattenelement in der Regel während des Herstellungsprozesses technisch einfach änderbar bzw. anpassbar, da das zweite Leiterplattenelement einen flexiblen oder semiflexiblen bzw. biegsamen Bereich umfasst. Darüber hinaus muss im Allgemeinen die Sensoreinheit bzw. das Sensorelement Prozesse zum Bedecken von elektronischen Bauelementen auf dem ersten Leiterplattenelement nicht durchlaufen, sondern kann erst nach diesen Prozessen angeordnet werden. Daher muss die Sensoreinheit bzw. das Sensorelement typischerweise, insbesondere gegenüber Erwärmung bzw. Hitze, nicht besonders widerstandsfähig ausgebildet sein. Zudem werden in der Regel keine zusätzlichen Verbindungselemente, wie z.B. Stanzgitter und/oder Kabel, zum elektrischen Verbinden des Sensorelements mit dem ersten Leiterplattenelement benötigt. Die Länge des zweiten Teilbereichs des zweiten Leiterplattenelements kann in der Regel auf die benötigte Verbindungslänge zwischen der Sensoreinheit bzw. der Sensoreinheit und dem ersten Leiterplattenelement angepasst sein. Ein Vorteil hiervon ist auch, dass typischerweise der elektrische Verbindungsbereich zwischen dem zweiten Teilbereich des zweiten Leiterplattenelements und dem ersten Leiterplattenelement besonders gut gegen die Umgebung geschützt ist. Insbesondere wird auch bei einer Formveränderung des Sensoreinheitträgers in der Regel der elektrische Verbindungsbereich bzw. die elektrische Verbindung nicht negativ beeinträchtigt, da das Material des Sensoreinheitträgers einen Abstand zu dem elektrischen Verbindungsbereich aufweist.

Gemäß einem zweiten Aspekt der Erfindung wird ein Verfahren zum Herstellen eines elektronischen Steuermoduls, insbesondere für ein Getriebe, vorgeschlagen, wobei das Verfahren folgende Schritte umfasst: - Bereitstellen eines ersten Leiterplattenelements; - Bereitstellen einer Sensoreinheit, wobei die Sensoreinheit ein zweites Leiterplattenelement, welches durch einen flexiblen Bereich in einen ersten Teilbereich und einen zweiten Teilbereich getrennt ist, wobei der erste Teilbereich einen vorbestimmten Winkel zu dem zweiten Teilbereich aufweist, wobei die Sensoreinheit ferner ein auf dem ersten Teilbereich des zweiten Leiterplattenelements befestigtes und mit dem zweiten Leiterplattenelement elektrisch verbundenes Sensorelement zum Erfassen mindestens einen Messwerts aufweist, wobei das Sensorelement durch ein Abdichtungsmaterial gegenüber der Umgebung öldicht abgeschlossen ist; - Anordnen eines Sensoreinheitträgers auf dem ersten Leiterplattenelement und Verbinden des Sensoreinheitträgers mit dem ersten Leiterplattenelement, wobei der Sensoreinheitträger eine Sensoreinheitaufnahme zum Aufnehmen der Sensoreinheit aufweist; und - Anordnen und Befestigen der Sensoreinheit in der Sensoreinheitaufnahme derart, dass der Sensor mittels des zweiten Teilbereichs elektrisch mit dem ersten Leiterplattenelement verbunden wird, wobei die Sensoreinheit derart angeordnet und mit dem Sensoreinheitträger verbunden wird, dass ein Hohlraum des Sensoreinheitträgers, in dem eine elektrische Verbindung von dem zweiten Teilbereich mit dem ersten Leiterplattenelement hergestellt wird, durch die Sensoreinheit von der Umgebung öldicht abgeschlossen ist.

Vorteilhaft hieran ist, dass in der Regel die Höhe bzw. der Abstand des Sensors bzw. der Sensoreinheit von dem ersten Leiterplattenelement durch Ändern der Höhe des Sensoreinheitträgers während des Herstellungsprozesses technisch einfach angepasst bzw. geändert werden kann. Zudem ist der Winkel zwischen dem Sensor bzw. der Sensoreinheit und dem ersten Leiterplattenelement typischerweise technisch einfach änderbar bzw. anpassbar, da das zweite Leiterplattenelement einen flexiblen oder semiflexiblen bzw. biegsamen Bereich umfasst. Durch Biegen des flexiblen bzw. semiflexiblen Teilbereichs des zweiten Leiterplattenelements (vor dem öldichten Abdichten mit Abdichtungsmaterial) kann in der Regel ein beliebiger Winkel zwischen dem Sensor und dem ersten Leiterplattenelement erreicht werden. Die (an die Höhe des Sensoreinheitträgers) anpassbare Länge des zweiten Teilbereichs des zweiten Leiterplattenelements sorgt typischerweise für eine sichere elektrische Verbindung zwischen dem Sensor bzw. der Sensoreinheit und dem ersten Leiterplattenelement ohne zusätzliche Elemente, wie z.B. Kabel und/oder Stanzgitter. Vorteilhaft hieran ist auch, dass typischerweise die elektrische Verbindung bzw. der elektrische Verbindungsbereich zwischen dem zweiten Teilbereich des Leiterplattenelements und dem ersten Leiterplattenelement technisch besonders einfach gegenüber der Umgebung geschützt wird. Es werden im Allgemeinen insbesondere keine zusätzlichen Schritte und/oder zusätzliche Elemente bzw. Komponenten zum Abdichten des Hohlraums und der elektrischen Verbindung benötigt.

Ideen zu Ausführungsformen der vorliegenden Erfindung können unter anderem als auf den nachfolgend beschriebenen Gedanken und Erkenntnissen beruhend angesehen werden.

Gemäß einer Ausführungsform umfasst der Sensoreinheitträger einen thermoplastischen Kunststoff, insbesondere besteht der Sensoreinheitträger aus einem thermoplastischen Kunststoff. Vorteilhaft hieran ist, dass das Steuermodul im Allgemeinen technisch kostengünstig herstellbar ist, da thermoplastischer Kunststoff günstig ist.

Gemäß einer Ausführungsform ist der zweite Teilbereich des zweiten Leiterplattenelements mit dem ersten Leiterplattenelement mittels einer Federkontaktverbindung elektrisch verbunden. Ein Vorteil hiervon ist, dass die elektrische Verbindung typischerweise technisch einfach und ohne Sicht bzw. Zugang zu der Federkontaktverbindung von außen hergestellt werden kann.

Gemäß einer Ausführungsform ist das Sensorelement, insbesondere die Sensoreinheit, und der flexible Bereich des zweiten Leiterplattenelements, durch ein Duroplastmaterial gegenüber der Umgebung öldicht abgedichtet. Hierdurch ist in der Regel die elektrische Verbindung bzw. der elektrische Verbindungsbereich zwischen dem zweiten Teilbereich des Leiterplattenelements und dem ersten Leiterplattenelement technisch besonders einfach gegenüber der Umgebung geschützt.

Gemäß einer Ausführungsform des Verfahrens werden vor dem Anordnen und Befestigen der Sensoreinheit in der Sensoreinheitaufnahme folgende Schritte ausgeführt: Aufbringen eines Vergussmaterials zum öldichten Abdichten von elektrischen Bauelementen auf dem ersten Leiterplattenelement gegenüber der Umgebung; und Aushärten des Vergussmaterials. Vorteilhaft hieran ist, dass typischerweise die Sensoreinheit erst nach dem Aushärten des Vergussmaterials an dem Sensoreinheitträger angebracht wird. Folglich wird in der Regel die Sensoreinheit von den Auswirkungen des Aushärtens des Vergussmaterials bzw. Maßnahmen zum Aushärten des Vergussmaterials (z.B. Erwärmen) verschont. Daher kann die Sensoreinheit im Allgemeinen aus einem kostengünstigen Material bestehen bzw. ein solches umfassen, insbesondere ein Material, das wärmeempfindlich ist.

Gemäß einer Ausführungsform des Verfahrens wird der zweite Teilbereich des zweiten Leiterplattenelements mit dem ersten Leiterplattenelement mittels einer Federkontaktverbindung elektrisch verbunden. Vorteilhaft hieran ist, dass die elektrische Verbindung in der Regel technisch einfach und ohne Sicht bzw. Zugang zu der Federkontaktverbindung von außen hergestellt wird.

Gemäß einer Ausführungsform des Verfahrens wird eine Höhe des Sensoreinheitträgers auf eine vorgegebene Höhe durch Entfernen eines Teils des Sensoreinheitträgers angepasst. Hierdurch kann typischerweise der Abstand des Sensors bzw. der Sensoreinheit von dem ersten Leiterplattenelement technisch einfach angepasst bzw. auf eine vorgegebene/gewünschte Höhe eingestellt werden.

Es wird darauf hingewiesen, dass einige der möglichen Merkmale und Vorteile der Erfindung hierin mit Bezug auf unterschiedliche Ausführungsformen des elektronischen Steuermoduls bzw. des Verfahrens zum Herstellen eines elektronischen Steuermoduls beschrieben sind. Ein Fachmann erkennt, dass die Merkmale in geeigneter Weise kombiniert, angepasst oder ausgetauscht werden können, um zu weiteren Ausführungsformen der Erfindung zu gelangen.

### Kurze Beschreibung der Zeichnungen

Nachfolgend werden Ausführungsformen der Erfindung unter Bezugnahme auf die beigefügte Zeichnung beschrieben, wobei weder die Zeichnung noch die Beschreibung als die Erfindung einschränkend auszulegen sind.

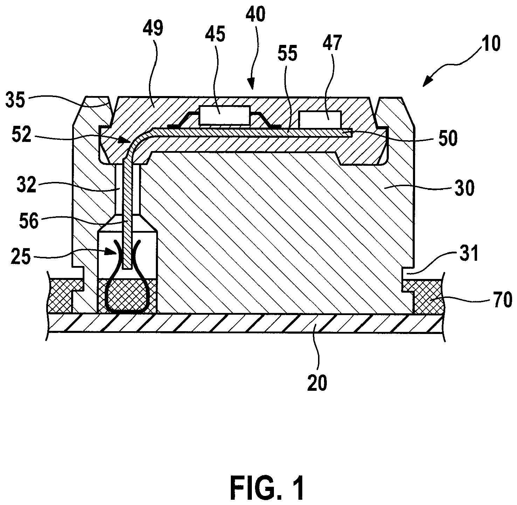

- Fig. 1 zeigt: eine Querschnittsansicht einer Ausführungsform des erfindungsgemäßen elektronischen Steuermoduls.

Die Figur ist lediglich schematisch und nicht maßstabsgetreu.

### Ausführungsformen der Erfindung

Fig. 1 zeigt eine Querschnittsansicht einer Ausführungsform des erfindungsgemäßen elektronischen Steuermoduls 10. Das elektronische Steuermodul 10 ist z.B. Teil einer Steuerung für ein Getriebe. Auch vorstellbar ist, dass das Steuermodul 10 in einem Elektrofahrzeug verwendet wird.

Das elektronische Steuermodul 10 umfasst ein erstes Leiterplattenelement 20.

Das erste Leiterplattenelement 20 kann z.B. ein printed-circuit-board (PCB) sein. Auf dem ersten Leiterplattenelement 20 können elektronische Bauelemente angeordnet sein.

Zumindest ein Teil des ersten Leiterplattenelements 20 ist von einem Vergussmaterial 70 bedeckt. Das Vergussmaterial 70 bedeckt elektronische Bauelemente, die auf dem ersten Leiterplattenelement 20 angeordnet sind, und schützt diese gegenüber der Umgebung. Das Vergussmaterial 70 ist öldicht ausgebildet, so dass die elektronischen Bauelemente gegenüber einer Ölumgebung, in der das Steuermodul 10 angeordnet sein kann, abgedichtet sind.

Auf dem ersten Leiterplattenelement 20 ist ein Sensoreinheitträger 30 angeordnet und an dem ersten Leiterplattenelement 20 befestigt. Der Sensoreinheitträger 30 kann mittels des Vergussmaterials 70, das zumindest teilweise in einer hierfür vorgesehen (umlaufenden) seitlichen Aussparung 31 des Sensoreinheitträgers 30 vorhanden ist, an dem ersten Leiterplattenelement 20 befestigt werden. Alternativ oder zusätzlich kann der Sensoreinheitträger 30 durch Löten (insbesondere Rewflow-Löten) an dem ersten Leiterplattenelement 20 befestigt sein.

Die Position des Sensoreinheitträgers 30 auf dem ersten Leiterplattenelement 20 ist während der Herstellung des elektronischen Steuermoduls 10 leicht anpassbar bzw. veränderbar, da lediglich die Position des elektrischen Verbindungselements (z.B. des Federkontaktelements 25) zwischen dem zweiten Leiterplattenelement 50 und dem ersten Leiterplattenelement 20 auf dem ersten Leiterplattenelement 20 verändert werden muss.

Der Sensoreinheitträger 30 kann einen thermoplastischen Kunststoff (z.B. PPS) umfassen oder aus diesem bestehen. Die Höhe (die senkrecht zum ersten Leiterplattenelement 20 verläuft; die in Fig. 1 von unten nach oben verläuft) des Sensoreinheitträgers 30 ist veränderbar. Hierzu kann ein in Fig. 1 unterer Abschnitt bzw. Bereich des Sensoreinheitträgers 30 vor dem Anordnen des Sensoreinheitträgers 30 auf dem ersten Leiterplattenelement 20 entfernt werden, z.B. abgeschnitten oder abgefräst werden. Der Sensoreinheitträger 30 liegt plan auf dem ersten Leiterplattenelement 20 auf.

Auf der dem ersten Leiterplattenelement 20 abgewandten Seite weist der Sensoreinheitträger 30 eine Sensoreinheitaufnahme 35 aus. Die Sensoreinheitaufnahme 35 kann z.B. eine Vertiefung umfassen bzw. sein. In der Sensoreinheitaufnahme 35 ist eine Sensoreinheit 40 angeordnet und an dem Sensoreinheitträger 30 befestigt. Die Befestigung kann durch Kleben und/oder Stecken erreicht werden. Die Sensoreinheit 40 kann nach dem Aufbringen und Aushärten des Vergussmaterials 70 angeordnet und befestigt werden.

Die Sensoreinheit 40 weist ein zweites Leiterplattenelement 50 auf. Das zweite Leiterplattenelement 50 kann z.B. ein printed-circuit-board sein. Auf dem zweiten Leiterplattenelement 50 sind ein Sensorelement 45 zum Erfassen mindestens eines Messwerts (z.B. eine Umdrehungszahl) sowie u.U. weitere elektronische Bauelemente 47 angeordnet und befestigt. Das Sensorelement 45 und die gegebenenfalls vorhandenen weiteren elektronischen Bauelemente 47 sind von einem Abdichtungsmaterial 49 umgeben, so dass das Sensorelement 45 und die weiteren elektronischen Bauelemente 47 gegenüber der Umgebung, öldicht insbesondere getriebeöldicht (dicht gegenüber automatic transmission fluid), abgedichtet sind. Das Abdichtungsmaterial 49 kann insbesondere ein duroplastisches Material umfassen oder ein solches sein.

Das zweite Leiterplattenelement 50 weist einen flexiblen bzw. semiflexiblen biegsamen Teilbereich bzw. Bereich 52 auf, der das zweite Leiterplattenelement 50 in einen ersten Teilbereich 55 (in Fig. 1 von oben nach unten verlaufend) und einen zweiten Teilbereich 56 (in Fig. 1 von links nach rechts verlaufend) trennt bzw. aufteilt. Der flexible Bereich 52 des zweiten Leiterplattenelements 50 kann insbesondere durch Entfernen eines Teils des zweiten Leiterplattenelements 50 ausgebildet werden. Hierzu wird zumindest auf einer ersten Seite des zweiten Leiterplattenelements 50 ein Teil des zweiten Leiterplattenelements 50 entfernt. Das zweite Leiterplattenelement 50 wird sozusagen in dem flexiblen Bereich 52 verdünnt. Zusätzlich kann auch auf einer der ersten Seite des zweiten Leiterplattenelements 50 gegenüberliegenden zweiten Seite des Leiterplattenelements 50 ein Teil des zweiten Leiterplattenelements 50 entfernt werden. Dies kann z.B. durch Abfräsen durchgeführt. Anschließend ist das zweite Leiterplattenelement 50 im flexiblen Bereich 52 biegsam. Der maximal erreichbare Winkel zwischen dem ersten Teilbereich 55 und dem zweiten Teilbereich 56 kann z.B. ca. 120° oder ca. 150° betragen.

Durch Veränderung der Position des flexiblen Bereichs 52 des zweiten Leiterplattenelements 50 kann die Länge des zweiten Teilbereichs 56 des zweiten Leiterplattenelements 50 eingestellt werden. Dies wird an die Höhe des Sensoreinheitträgers 30 angepasst, so dass durch Einführen des zweiten Teilbereichs 56 des zweiten Leiterplattenelements 50 in den Hohlraum 32 des Sensoreinheitträgers 30 sicher eine elektrische Verbindung mit dem ersten Leiterplattenelement 20 hergestellt wird.

Das Biegen des flexiblen Bereichs 52 wird vor dem Umgeben des Sensorelements 45 und des ersten Teilbereichs 55 des zweiten Leiterplattenelements 50 mit dem Abdichtungsmaterial 49 ausgeführt, d.h. vor dem Abdichten der Sensoreinheit 40. Das Umgeben kann z.B. durch Umspritzen durchgeführt werden. Der flexible Bereich 52 wird derart gebogen, dass ein vorgegebener bzw. gewünschter Winkel zwischen dem ersten Teilbereich 55 des zweiten Leiterplattenelements 50 und dem zweiten Teilbereich 56 des zweiten Leiterplattenelements 50 erreicht wird. Da der Winkel zwischen dem zweiten Teilbereich 56 des zweiten Leiterplattenelements 50 und dem ersten Leiterplattenelement 20 üblicherweise ca. 90° beträgt, ist hierdurch auch der Winkel zwischen dem ersten Leiterplattenelement 20 und dem Sensorelement 45 bzw. dem ersten Teilbereich 55 des zweiten Leiterplattenelements 50 eingestellt. Unabhängig von dem Winkel des Sensorelements 45 zu dem ersten Leiterplattenelement 20 kann somit der zweite Teilbereich 56 des zweiten Leiterplattenelements 50 stets einen Winkel von ca. 90° zu dem ersten Leiterplattenelement 20 aufweisen. Dies erleichtert die elektrische Verbindung zwischen dem zweiten Leiterplattenelement 50 und dem ersten Leiterplattenelement 20.

Der Sensoreinheitträger 30 kann auf den Winkel zwischen dem ersten Teilbereich 55 und dem zweiten Teilbereich 56 angepasst sein, so dass die von dem ersten Leiterplattenelement 10 abgewandte Seite des Sensoreinheitträgers 30 im Wesentlichen parallel zu dem ersten Teilbereich 55 des zweiten Leiterplattenelements 50 verläuft. Umgekehrt kann die Sensoreinheit 40 auf den Sensoreinheitträger 30 entsprechend angepasst sein.

Das Abdichtungsmaterial 49 umgibt den flexiblen Bereich 52 des zweiten Leiterplattenelements 50 vollständig. Ein Teil des zweiten Teilbereichs 56 des zweiten Leiterplattenelements 50 kann von dem Abdichtungsmaterial 49 umgeben sein. Vorstellbar ist jedoch auch, dass der zweite Teilbereich 56 des zweiten Leiterplattenelements 50 von Abdichtungsmaterial 49 frei ist.

Ein dem flexiblen Bereich 52 des zweiten Leiterplattenelements 50 abgewandtes Ende des zweiten Teilbereichs 56 des zweiten Leiterplattenelements 50 wird über eine (SMD-)Federkontaktverbindung mit dem ersten Leiterplattenelement 20 elektrisch verbunden. Da der zweite Teilbereich 56 des zweiten Leiterplattenelements 50 über den flexiblen Bereich 52 des zweiten Leiterplattenelements 50 und den ersten Teilbereich 55 des zweiten Leiterplattenelements 50 mit dem Sensorelement 45 elektrisch verbunden ist, ist hierdurch das Sensorelement 45 mit dem ersten Leiterplattenelement 20 elektrisch verbunden.

Der Sensoreinheitträger 30 weist einen Hohlraum 32 auf, der zu dem ersten Leiterplattenelement 20 hin offen ist. Der zweite Teilbereich 56 des zweiten Leiterplattenelements 50 wird in den Hohlraum 32 eingeführt und gelangt aufgrund einer Führung des Sensoreinheitträgers 30 in das Federkontaktelement 25.

Der Hohlraum 32 ist in Richtung von dem ersten Leiterplattenelement 20 weg durch die Sensoreinheit 40, insbesondere durch das Abdichtungsmaterial 49 der Sensoreinheit 40, öldicht gegenüber der Umgebung abgedichtet. Hierdurch sind der Hohlraum 32 und elektrische Kontakt zwischen dem zweiten Teilbereich 56 des zweiten Leiterplattenelements 50 und dem ersten Leiterplattenelement 20 technisch einfach öldicht gegenüber der Umgebung abgedichtet.

Abschließend ist darauf hinzuweisen, dass Begriffe wie "aufweisend", "umfassend", etc. keine anderen Elemente oder Schritte ausschließen und Begriffe wie "eine" oder "ein" keine Vielzahl ausschließen. Bezugszeichen in den Ansprüchen sind nicht als Einschränkung anzusehen.

## Patentansprüche

1. Elektronisches Steuermodul (10), insbesondere für ein Getriebe, umfassend
- ein erstes Leiterplattenelement (20),
- einen auf dem ersten Leiterplattenelement (20) befestigten Sensoreinheitträger (30) mit einer Sensoreinheitaufnahme (35) zum Aufnehmen einer Sensoreinheit (40),
- die Sensoreinheit (40) mit einem auf einem zweiten Leiterplattenelement (50) befestigten und mit dem zweiten Leiterplattenelement (50) elektrisch verbundenen Sensorelement (45) zum Erfassen mindestens einen Messwerts,
wobei die Sensoreinheit (40) in der Sensoreinheitaufnahme (35) befestigt ist, wobei
das zweite Leiterplattenelement (50) einen flexiblen Bereich (52) aufweist, wobei der flexible Bereich (52) einen ersten Teilbereich (55) des zweiten Leiterplattenelements (50) von einem zweiten Teilbereich (56) des zweiten Leiterplattenelements (50) trennt, wobei der erste Teilbereich (55) einen vorbestimmten Winkel zu dem zweiten Teilbereich (56) aufweist, und
das Sensorelement (45) mittels des zweiten Teilbereichs (56) des zweiten Leiterplattenelements (50) mit dem ersten Leiterplattenelement (20) elektrisch verbunden ist,
wobei der Sensoreinheitträger (30) einen Hohlraum (32) zum Aufnehmen eines elektrischen Verbindungsbereichs zwischen dem zweiten Teilbereich (56) des zweiten Leiterplattenelements (50) und dem ersten Leiterplattenelement (20) aufweist,
**dadurch gekennzeichnet, dass**
der Hohlraum (32) gegenüber der Umgebung durch die Sensoreinheit (40) öldicht abgedichtet ist.

2. Elektronisches Steuermodul (10) nach Anspruch 1, wobei
der Sensoreinheitträger (30) einen thermoplastischen Kunststoff umfasst, insbesondere aus einem thermoplastischen Kunststoff besteht.

3. Elektronisches Steuermodul (10) nach Anspruch 1 oder 2, wobei
der zweite Teilbereich (56) des zweiten Leiterplattenelements (50) mit dem ersten Leiterplattenelement (20) mittels einer Federkontaktverbindung (25) elektrisch verbunden ist.

4. Elektronisches Steuermodul (10) nach einem der vorhergehenden Ansprüche, wobei
das Sensorelement (45), insbesondere die Sensoreinheit (40), und der flexible Bereich (52) des zweiten Leiterplattenelements (50), durch ein Duroplastmaterial gegenüber der Umgebung öldicht abgedichtet ist.

5. Verfahren zum Herstellen eines elektronischen Steuermoduls (10), insbesondere für ein Getriebe, wobei das Verfahren folgende Schritte umfasst:
- Bereitstellen eines ersten Leiterplattenelements (20);
- Bereitstellen einer Sensoreinheit (40), wobei die Sensoreinheit (40) ein zweites Leiterplattenelement (50), welches durch einen flexiblen Bereich (52) in einen ersten Teilbereich (55) und einen zweiten Teilbereich (56) getrennt ist, wobei der erste Teilbereich (55) einen vorbestimmten Winkel zu dem zweiten Teilbereich (56) aufweist, wobei die Sensoreinheit (40) ferner ein auf dem ersten Teilbereich (55) des zweiten Leiterplattenelements (50) befestigtes und mit dem zweiten Leiterplattenelement (50) elektrisch verbundenes Sensorelement (45) zum Erfassen mindestens einen Messwerts aufweist, wobei das Sensorelement (45) durch ein Abdichtungsmaterial (49) gegenüber der Umgebung öldicht abgeschlossen ist;
- Anordnen eines Sensoreinheitträgers (30) auf dem ersten Leiterplattenelement (20) und Verbinden des Sensoreinheitträgers (30) mit dem ersten Leiterplattenelement (20), wobei der Sensoreinheitträger (30) eine Sensoreinheitaufnahme (35) zum Aufnehmen der Sensoreinheit (40) aufweist; und
- Anordnen und Befestigen der Sensoreinheit (40) in der Sensoreinheitaufnahme (35) derart, dass das Sensorelement (45) mittels des zweiten Teilbereichs (56) elektrisch mit dem ersten Leiterplattenelement (20) verbunden wird,
wobei die Sensoreinheit (40) derart angeordnet und mit dem Sensoreinheitträger (30) verbunden wird, dass ein Hohlraum (32) des Sensoreinheitträgers (30), in dem eine elektrische Verbindung von dem zweiten Teilbereich (56) mit dem ersten Leiterplattenelement (20) hergestellt wird, durch die Sensoreinheit (40) von der Umgebung öldicht abgeschlossen ist.

6. Verfahren nach Anspruch 5, wobei
vor dem Anordnen und Befestigen der Sensoreinheit (40) in der Sensoreinheitaufnahme (35) folgende Schritte ausgeführt werden:
Aufbringen eines Vergussmaterials (70) zum öldichten Abdichten von elektrischen Bauelementen (47) auf dem ersten Leiterplattenelement (20) gegenüber der Umgebung; und
Aushärten des Vergussmaterials (70).

7. Verfahren nach Anspruch 5 oder 6, wobei
der zweite Teilbereich (56) des zweiten Leiterplattenelements (50) mit dem ersten Leiterplattenelement (20) mittels einer Federkontaktverbindung elektrisch verbunden wird.

8. Verfahren nach einem der Ansprüche 5-7, wobei
eine Höhe des Sensoreinheitträgers (30) auf eine vorgegebene Höhe durch Entfernen eines Teils des Sensoreinheitträgers (30) angepasst wird.

## Claims

1. Electronic control module (10), in particular for a transmission, comprising
- a first printed circuit board element (20),
- a sensor unit support (30) which is fixed on the first printed circuit board element (20) and has a sensor unit receptacle (35) for receiving a sensor unit (40),
- the sensor unit (40) with a sensor element (45), which is fixed on a second printed circuit board element (50) and is electrically connected to the second printed circuit board element (50), for detecting at least one measurement value,
wherein the sensor unit (40) is fixed in the sensor unit receptacle (35),
wherein
the second printed circuit board element (50) has a flexible region (52),
wherein the flexible region (52) separates a first subregion (55) of the second printed circuit board element (50) from a second subregion (56) of the second printed circuit board element (50), wherein the first subregion (55) is at a predetermined angle in relation to the second subregion (56), and the sensor element (45) is electrically connected to the first printed circuit board element (20) by means of the second subregion (56) of the second printed circuit board element (50),
wherein the sensor unit support (30) has a hollow space (32) for receiving an electrical connecting region between the second subregion (56) of the second printed circuit board element (50) and the first printed circuit board element (20),
**characterized in that**
the hollow space (32) is sealed off in an oil-tight manner from the surrounding area by the sensor unit (40).

2. Electronic control module (10) according to Claim 1, wherein
the sensor unit support (30) comprises a thermoplastic, in particular consists of a thermoplastic.

3. Electronic control module (10) according to Claim 1 or 2, wherein
the second subregion (56) of the second printed circuit board element (50) is electrically connected to the first printed circuit board element (20) by means of a spring contact connection (25).

4. Electronic control module (10) according to any one of the preceding claims, wherein
the sensor element (45), in particular the sensor unit (40), and the flexible region (52) of the second printed circuit board element (50) is sealed off in an oil-tight manner from the surrounding area by a thermoset material.

5. Method for producing an electronic control module (10), in particular for a transmission, wherein the method comprises the following steps:
- providing a first printed circuit board element (20) ;
- providing a sensor unit (40), wherein the sensor unit (40) has a second printed circuit board element (50) which is separated by a flexible region (52) into a first subregion (55) and a second subregion (56), wherein the first subregion (55) is at a predetermined angle in relation to the second subregion (56), wherein the sensor unit (40) further has a sensor element (45), which is fixed on the first subregion (55) of the second printed circuit board element (50) and is electrically connected to the second printed circuit board element (50), for detecting at least one measurement value, wherein the sensor element (45) is closed off in an oil-tight manner from the surrounding area by a sealing-off material (49);
- arranging a sensor unit support (30) on the first printed circuit board element (20) and connecting the sensor unit support (30) to the first printed circuit board element (20), wherein the sensor unit support (30) has a sensor unit receptacle (35) for receiving the sensor unit (40); and
- arranging and fixing the sensor unit (40) in the sensor unit receptacle (35) in such a way that the sensor element (45) is electrically connected to the first printed circuit board element (20) by means of the second subregion (56),
wherein the sensor unit (40) is arranged and connected to the sensor unit support (30) in such a way that a hollow space (32) of the sensor unit support (30), in which an electrical connection is established between the second subregion (56) and the first printed circuit board element (20), is closed off in an oil-tight manner from the surrounding area by the sensor unit (40).

6. Method according to Claim 5, wherein,
before arranging and fixing the sensor unit (40) in the sensor unit receptacle (35), the following steps are executed:
applying an encapsulation material (70) for sealing off electrical components (47) on the first printed circuit board element (20) in an oil-tight manner from the surrounding area; and
curing the encapsulation material (70).

7. Method according to Claim 5 or 6, wherein
the second subregion (56) of the second printed circuit board element (50) is electrically connected to the first printed circuit board element (20) by means of a spring contact connection.

8. Method according to any one of Claims 5-7, wherein a height of the sensor unit support (30) is matched to a prespecified height by removing a portion of the sensor unit support (30).

## Revendications

1. Module de commande électronique (10), en particulier pour une transmission, comprenant
- un premier élément de carte de circuits imprimés (20),
- un support d'unité de capteur (30) fixé sur le premier élément de carte de circuits imprimés (20), doté d'un logement d'unité de capteur (35) destiné à recevoir une unité de capteur (40),
- l'unité de capteur (40) dotée d'un élément de capteur (45) fixé sur un deuxième élément de carte de circuits imprimés (50) et relié électriquement au deuxième élément de carte de circuits imprimés (50), destiné à détecter au moins une valeur de mesure, l'unité de capteur (40) étant fixée dans le logement d'unité de capteur (35), dans lequel
le deuxième élément de carte de circuits imprimés (50) présente une zone flexible (52), la zone flexible (52) séparant une première zone partielle (55) du deuxième élément de carte de circuits imprimés (50) par rapport à une deuxième zone partielle (56) du deuxième élément de carte de circuits imprimés (50), la première zone partielle (55) présentant un angle prédéterminé par rapport à la deuxième zone partielle (56), et
l'élément de capteur (45) est relié électriquement au premier élément de carte de circuits imprimés (20) au moyen de la deuxième zone partielle (56) du deuxième élément de carte de circuits imprimés (50),
le support d'unité de capteur (30) présentant une cavité (32) destinée à recevoir une zone de liaison électrique entre la deuxième zone partielle (56) du deuxième élément de carte de circuits imprimés (50) et le premier élément de carte de circuits imprimés (20),
**caractérisé en ce que** la cavité (32) est rendue étanche à l'huile par rapport à l'environnement par l'unité de capteur (40).

2. Module de commande électronique (10) selon la revendication 1, dans lequel le support d'unité de capteur (30) comprend une matière thermoplastique, étant en particulier composé d'une matière thermoplastique.

3. Module de commande électronique (10) selon la revendication 1 ou 2, dans lequel la deuxième zone partielle (56) du deuxième élément de carte de circuits imprimés (50) est reliée électriquement au premier élément de carte de circuits imprimés (20) au moyen d'une liaison par contact à ressort (25).

4. Module de commande électronique (10) selon l'une quelconque des revendications précédentes, dans lequel l'élément de capteur (45), en particulier l'unité de capteur (40), et la zone flexible (52) du deuxième élément de carte de circuits imprimés (50) sont rendus étanches à l'huile par rapport à l'environnement par un matériau thermodurcissable.

5. Procédé de fabrication d'un module de commande électronique (10), en particulier pour une transmission, le procédé comprenant les étapes suivantes consistant à :
- prévoir un premier élément de carte de circuits imprimés (20) ;
- prévoir une unité de capteur (40), l'unité de capteur (40) présentant un deuxième élément de carte de circuits imprimés (50) qui est séparé par une zone flexible (52) en une première zone partielle (55) et une deuxième zone partielle (56), la première zone partielle (55) présentant un angle prédéterminé par rapport à la deuxième zone partielle (56), l'unité de capteur (40) présentant en outre un élément de capteur (45) fixé sur la première zone partielle (55) du deuxième élément de carte de circuits imprimés (50) et relié électriquement au deuxième élément de carte de circuits imprimés (50), servant à détecter au moins une valeur de mesure, l'élément de capteur (45) étant rendu étanche à l'huile par rapport à l'environnement par un matériau d'étanchéité (49) ;
- disposer un support d'unité de capteur (30) sur le premier élément de carte de circuits imprimés (20) et relier le support d'unité de capteur (30) au premier élément de carte de circuits imprimés (20), le support d'unité de capteur (30) présentant un logement d'unité de capteur (35) servant à recevoir l'unité de capteur (40) ; et
- disposer et fixer l'unité de capteur (40) dans le logement d'unité de capteur (35) de telle sorte que l'élément de capteur (45) est relié électriquement au premier élément de carte de circuits imprimés (20) au moyen de la deuxième zone partielle (56),
l'unité de capteur (40) étant disposée et reliée au support d'unité de capteur (30) de telle sorte qu'une cavité (32) du support d'unité de capteur (30) dans laquelle une liaison électrique de la deuxième zone partielle (56) au premier élément de carte de circuits imprimés (20) est établie, est fermé de manière étanche à l'huile par rapport à l'environnement par l'unité de capteur (40).

6. Procédé selon la revendication 5, dans lequel, avant de disposer et fixer l'unité de capteur (40) dans le logement d'unité de capteur (35), les étapes suivantes sont exécutées, consistant à :
appliquer un matériau de scellement (70) pour rendre des composants électriques (47) sur le premier élément de carte de circuits imprimés (20) étanches à l'huile par rapport à l'environnement ; et
laisser durcir le matériau (70).

7. Procédé selon la revendication 5 ou 6, dans lequel la deuxième zone partielle (56) du deuxième élément de carte de circuits imprimés (50) est reliée électriquement au premier élément de carte de circuits imprimés (20) au moyen d'une liaison par contact à ressort.

8. Procédé selon l'une quelconque des revendications 5 à 7, dans lequel une hauteur du support d'unité de capteur (30) est adaptée à une hauteur prédéfinie par enlèvement d'une partie du support d'unité de capteur (30) .
